# EUROPEAN PATENT APPLICATION

(11) **EP 4 502 405 A1**
(43) Date of publication of application: **05.02.2025**
(21) Application number: 23834483.2
(22) Date of filing: 28.04.2023
(51) Int. Cl.: F16C 11/04, F16C 11/10, F16C 11/12, H05K 5/02, H04M 1/02, G06F 1/16

(54) **SYNCHRONIZATION MECHANISM, ROTATING SHAFT MECHANISM AND ELECTRONIC DEVICE**

(30) Priority: 06.07.2022 CN 202210789257
(71) Applicant: Honor Device Co., Ltd., Shenzhen, Guangdong 518040 (CN)
(72) Inventor: GAO, Mingqian, Shenzhen, Guangdong 518040 (CN); ZHANG, Qiulong, Shenzhen, Guangdong 518040 (CN); FENG, Lei, Shenzhen, Guangdong 518040 (CN); YUAN, Leibo, Shenzhen, Guangdong 518040 (CN); LI, Haifei, Shenzhen, Guangdong 518040 (CN)
(74) Representative: MERH-IP Matias Erny Reichl Hoffmann Patentanwälte PartG mbB
(86) International application number: PCT/CN2023/091453
(87) International publication number: WO 2024/007706

(57) **Abstract**

A synchronization mechanism, a rotating shaft mechanism, and an electronic device are provided. The synchronization mechanism in this application may be applied to an electronic device such as a mobile phone, a tablet computer, a tablet computer accessory, or a wearable device. The synchronization mechanism includes a base, a slider, an elastic component, and a first swing arm and a second swing arm that are on two sides of the slider. A helical surface elastically abuts against an abutting portion under an action of the elastic component, so that the first swing arm and the second swing arm rotate at a same angle relative to the base. The elastic component can enable the helical surface and the abutting portion to be always in an abutting state during rotation of the swing arms, so that rotation synchronization of the swing arms on the two sides is improved. In addition, the helical surface is disposed on an end surface of the slider or a protruding portion of the swing arm. A processing technology is simple, and costs are low. In addition, in a manner in which the helical surface and the abutting portion fit with each other to implement axial sliding, relatively small space is occupied in a thickness direction of a mobile phone, and therefore, a thin and light design requirement of the electronic device such as a mobile phone is met.

## Description

This application claims priority to Chinese Patent Application No. 202210789257.4, filed with the China National Intellectual Property Administration on July 6, 2022 and entitled "SYNCHRONIZATION MECHANISM, ROTATING SHAFT MECHANISM, AND ELECTRONIC DEVICE", which is incorporated herein by reference in the entirety of embodiments of this application.

### TECHNICAL FIELD

This application relates to the field of electronic products, and in particular, to a synchronization mechanism, a rotating shaft mechanism, and an electronic device.

### BACKGROUND

Housings on two sides of an electronic device are connected to a rotating shaft mechanism, and the two housing are folded or unfolded relative to each other by using the rotating shaft mechanism. The rotating shaft mechanism includes a first swing arm and a second swing arm. The first swing arm and the second swing arm are respectively connected to the two housings, and when the two swing arms rotate, the housings are driven to be folded or unfolded. To enable the two swing arms to synchronously swing, the rotating shaft mechanism is configured with a synchronization mechanism. A current synchronization mechanism mainly has the following forms: a gear component, a worm and gear structure, and a rack and pinion structure. Each of the forms implements synchronization of the swing arms on the two sides by using meshing teeth. To ensure strength of the meshing teeth, a gear and a worm each have a minimum limiting size. Therefore, each synchronization mechanism occupies relatively large space. In addition, because each tooth meshing synchronization mechanism has a relatively large quantity of components, costs are relatively high, and assembly is complex.

### SUMMARY

Embodiments of this application provide a synchronization mechanism that has a simple structure and low costs and that occupies small space, a rotating shaft mechanism, and an electronic device.

In an embodiment, the synchronization mechanism includes a base, a slider, and a first swing arm and a second swing arm that are located on two sides of the slider. Both the first swing arm and the second swing arm are rotatably connected to the base. The slider is slidably disposed parallel to an axial direction in which the first swing arm and the second swing arm rotate.

A protruding portion is disposed on each of the first swing arm and the second swing arm, an end surface of one of the protruding portion and the slider has a helical surface, and an abutting portion that fits with the corresponding helical surface is disposed on an end surface of the other one of the protruding portion and the slider.

The synchronization mechanism further includes an elastic component, the helical surface elastically abuts against the abutting portion under an action of the elastic component, and when the first swing arm and the second swing arm rotate, the helical surface and the abutting portion fit with each other to drive the slider to axially slide, so that the first swing arm and the second swing arm rotate at a same angle relative to the base.

Compared with a helical groove disposed on a main body between two end surfaces of a slider, in this application, the helical surface is formed on an end surface of the slider, and the helical surface has no undercut structure, and may be directly formed by using a mold or formed through conventional numerical control processing. The formation technology is relatively simple. In addition, in a manner in which the helical surface and the abutting portion fit with each other to implement axial sliding, relatively small space is occupied in a thickness direction of a mobile phone, and therefore, a thin and light design requirement of an electronic device such as a mobile phone is met. In addition, under an action of a restoring force of the elastic component, the helical surface and the abutting portion elastically abut against each other, in other words, the elastic component is axially in a compressed state. In this way, the elastic component can enable the helical surface and the abutting portion to be always in an abutting state during rotation of the swing arms, so that rotation synchronization of the swing arms on the two sides is improved.

In an example, both the first swing arm and the second swing arm are of a split-type structure, the first swing arm and the second swing arm each include a first swing sub-arm and a second swing sub-arm that are capable of synchronously rotating, the first swing sub-arm and the second swing sub-arm are capable of axially moving relative to each other, and at least one of the first swing sub-arm and the second swing sub-arm has the protruding portion. In this example, the first swing arm and the second swing arm are disposed as being of a split-type structure, to facilitate arrangement of the elastic component, so that design flexibility of the mechanism is improved.

In an example, a protruding portion A is disposed on the first swing sub-arm, a protruding portion B is disposed on the second swing sub-arm, an abutting portion is disposed on each of corresponding end surfaces of the protruding portion A and the protruding portion B, the slider is located between a protruding portion A and a protruding portion B on a same side, and under the action of the elastic component, two axially arranged end surfaces of the slider respectively elastically abut against the protruding portion A and the protruding portion B on the same side.

In an example, the synchronization mechanism further includes a first rotating shaft and a second rotating shaft that are mounted on the base. The first rotating shaft and the second rotating shaft are disposed in parallel, the first swing arm rotates around the first rotating shaft, the second swing arm rotates around the second rotating shaft, and the slider slides along the first rotating shaft and the second rotating shaft.

In an example, the protruding portion A and the protruding portion B are provided with coaxial via holes for a rotating shaft on a corresponding side to pass through.

In an example, a first sleeve is disposed on each of the two sides of the slider, the first sleeves on the two sides are respectively slidably sleeved on the first rotating shaft and the second rotating shaft, two end surfaces of each of the first sleeves have helical surfaces, and the helical surfaces respectively fit with the abutting portions of the protruding portion A and the protruding portion B.

In an example, a recess is disposed on one of non-hinged ends of the first swing sub-arm and the second swing sub-arm, a protrusion inserted into the recess is disposed on the other one of the non-hinged ends, and the protrusion fits with the recess to implement synchronous rotation between the first swing sub-arm and the second swing sub-arm.

In an example, the synchronization mechanism further includes a third swing arm and a fourth swing arm. The third swing arm and the fourth swing arm are respectively rotatably connected to two sides of the base. An elastic component is press-fitted between the third swing arm and the first swing arm and between the fourth swing arm and the second swing arm.

In an example, the synchronization mechanism further includes a damping apparatus. The damping apparatus includes an elastic damping component that is circumferentially limited by the base and that is capable of axially extending or retracting, the third swing arm and the fourth swing arm each have a first concave-convex surface, the elastic damping component has second concave-convex surfaces that are in a one-to-one correspondence with the first concave-convex surfaces and that elastically abut against the first concave-convex surfaces, and when the third swing arm and the fourth swing arm rotate, the first concave-convex surface rotates relative to the second concave-convex surface to provide damping.

In an example, two protruding portions C that are axially spaced apart are disposed on each of the third swing arm and the fourth swing arm, the protruding portion C is provided with a through hole for a rotating shaft on a corresponding side to pass through, and a first concave-convex surface is disposed on each of two opposite surfaces of the two protruding portions C.

In an example, the elastic damping component includes a first bracket, a second bracket, and a first elastic member, a second sleeve exists on each of two sides of each of the first bracket and the second bracket, the two second sleeves are respectively sleeved on the first rotating shaft and the second rotating shaft, the first elastic member is press-fitted between the first bracket and the second bracket, and a second concave-convex surface is disposed on an end portion that is of each of the second sleeves and that is away from the first elastic member.

In an example, the elastic component includes a first elastic component and a second elastic component, the first elastic component is located on an outer side of a rotating shaft of the first swing arm, two ends of the first elastic component are supported on non-hinged ends of the first swing arm and the third swing arm, the second elastic component is located on an outer side of a rotating shaft of the second swing arm, and two ends of the second elastic component are supported on non-hinged ends of the second swing arm and the fourth swing arm.

In an example, coaxial first holes are disposed on the third swing arm and non-hinged ends of a first swing sub-arm and a second swing sub-arm on a same side as the third swing arm, a first shaft body is disposed inside the first hole, the first elastic component is sleeved on the first shaft body, coaxial second holes are disposed on the fourth swing arm and non-hinged ends of a first swing sub-arm and a second swing sub-arm on a same side as the fourth swing arm, a second shaft body is disposed inside the second hole, and the second elastic component is sleeved on the second shaft body.

In an example, the elastic component includes two first elastic members, the two first elastic members are respectively sleeved on the first rotating shaft and the second rotating shaft, the first elastic member is circumferentially limited by the base, the second elastic member is circumferentially limited by the base, and at least one end portion of each of the first elastic member and the second elastic member is capable of abutting against and fitting with a concave-convex surface of a swing arm on a corresponding side to provide rotation damping.

In an example, the elastic component further includes a bracket, a second sleeve exists on each of two sides of the bracket, the two second sleeves are respectively sleeved on the first rotating shaft and the second rotating shaft, two elastic components abut against swing arms on corresponding sides by using the bracket, and the two second sleeves fit with concave-convex surfaces of swing arms corresponding to the two second sleeves.

In an example, the bracket includes a first bracket and a second bracket that are located at two ends of the elastic component, the first swing arm and the second swing arm respectively elastically abut against concave-convex surfaces of second sleeves on two sides of the first bracket, and the third swing arm and the fourth swing arm respectively elastically abut against concave-convex surfaces of second sleeves on two sides of the second bracket.

In an example, the elastic component further includes a second elastic member, the second elastic member is located between the two first elastic members, and a support for mounting the second elastic member is further disposed on each of opposite side surfaces of the first bracket and the second bracket.

In an example, the synchronization mechanism further includes a shaft body that runs through non-hinged ends of swing arms on a same side of the base. Driven by the shaft body, the swing arms on the same side of the base synchronously rotate.

In an example, a guide rail is disposed on one of two opposite surfaces of the base and the slider, a recess that is axially in sliding fit with the guide rail is disposed on the other one of the two opposite surfaces, and the guide rail and the recess axially extend.

According to a second aspect, this application further provides a rotating shaft mechanism, including a pedestal and the synchronization mechanism according to any one of the foregoing examples. The base is connected to the pedestal fixedly or in a limiting manner.

According to a third aspect, this application further provides an electronic device, including a flexible screen and the foregoing rotating shaft mechanism.

The rotating shaft mechanism and the electronic device in this application include the foregoing synchronization mechanism, and therefore, also have the foregoing technical effects of the synchronization mechanism.

### BRIEF DESCRIPTION OF DRAWINGS

FIG. 1 is a schematic diagram in which a rotating shaft mechanism provided in an embodiment of this application is applied to an electronic device;
FIG. 2 is a schematic exploded view of the electronic device shown in FIG. 1;
FIG. 3 is a partial schematic diagram existing after a rotating shaft mechanism and a main body portion in FIG. 2 are assembled;
FIG. 4 is a three-dimensional schematic diagram of a synchronization mechanism according to a first example of this application;
FIG. 5 is a front view of the synchronization mechanism in FIG. 4;
FIG. 6 is a schematic exploded view of the synchronization mechanism shown in FIG. 4;
FIG. 7 is a three-dimensional schematic diagram of a slider in FIG. 4;
FIG. 8 is a three-dimensional schematic diagram of a first swing arm in FIG. 4;
FIG. 9 is a three-dimensional schematic diagram of a first bracket in FIG. 4;
FIG. 10 is a schematic diagram of a first mounting block in FIG. 4 that constitutes a base;
FIG. 11 is a three-dimensional schematic diagram of a synchronization mechanism according to a second example of this application;
FIG. 12 is a three-dimensional schematic diagram of a first swing arm in FIG. 11;
FIG. 13 is a three-dimensional schematic diagram of a slider in FIG. 11;
FIG. 14 is a three-dimensional schematic diagram of a synchronization mechanism according to a third example of this application;
FIG. 15 is a schematic front view of FIG. 14;
FIG. 16 is a three-dimensional schematic diagram of a first swing arm in FIG. 14;
FIG. 17 is a three-dimensional schematic diagram of a synchronization mechanism according to a fourth example of this application;
FIG. 18 is a schematic exploded view of a first swing sub-arm and a second swing sub-arm in FIG. 17;
FIG. 19 is a schematic exploded view of the synchronization mechanism shown in FIG. 17; and
FIG. 20 is a schematic diagram of a structure of a synchronization mechanism according to a fifth example of this application.

### DESCRIPTION OF EMBODIMENTS

In descriptions of the embodiments of this application, it should be noted that an orientation relationship or a positional relationship indicated by terms "left", "right", "inner", "outer", and the like is an orientation relationship or a positional relationship shown based on the accompanying drawings, and is only for ease of describing a technology, rather than indicating or implying that an apparatus or an element referred to must have a specific orientation, or be constructed or operated in a specific orientation. Therefore, the terms should not be construed as a limitation on the present invention.

In the following descriptions, terms "first", "second", and the like are merely intended for a purpose of description, and should not be understood as an indication or implication of relative importance or implicit indication of a quantity of indicated technical features. Therefore, features defined with "first", "second", and the like can explicitly or implicitly include one or more of the features.

To enable a person skilled in the art to better understand the technical solutions of the present invention, the following further describes the present invention in detail with reference to the accompanying drawings and specific embodiments.

A rotating shaft mechanism provided in the embodiments of this application may be applied to an electronic device. The electronic device may be a mobile terminal, for example, a mobile phone, a tablet computer, a tablet computer accessory, a wearable device, a vehicle-mounted device, an augmented reality (augmented reality, AR)/a virtual reality (virtual reality, VR) device, a notebook computer, an ultra-mobile personal computer (ultra-mobile personal computer, UMPC), a netbook, or a personal digital assistant (personal digital assistant, PDA), or may be a professional photography device, for example, a digital camera, a single lens reflex camera/mirrorless camera, a motion camera, a pan-tilt-zoom camera, or an unmanned aerial vehicle. A specific type of the electronic device is not limited in the embodiments of this application. For ease of understanding, the following describes an example in which the electronic device is a mobile phone.

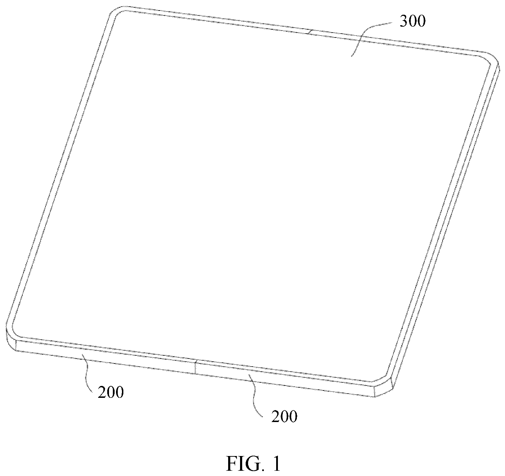

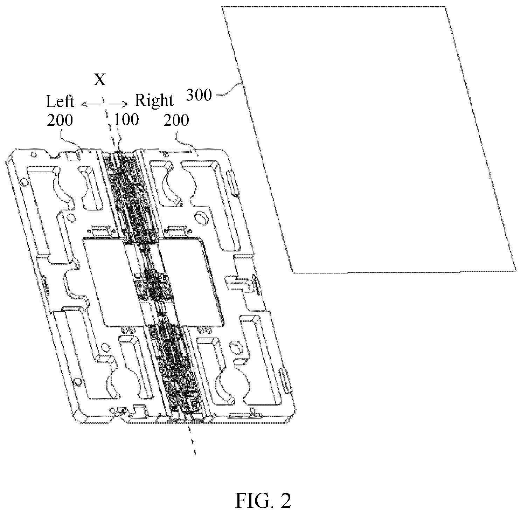

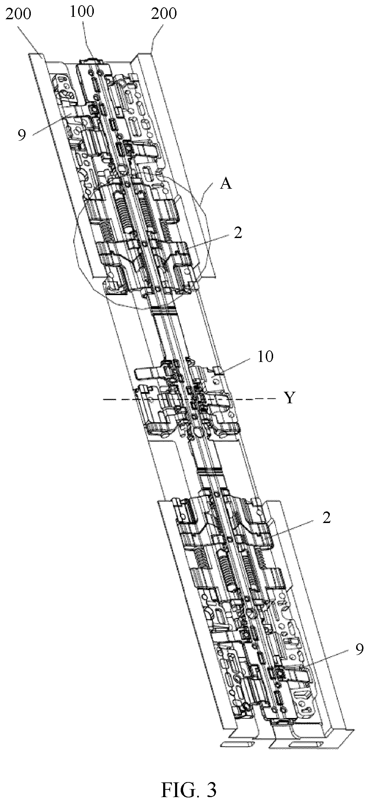

Refer to FIG. 1 to FIG. 3. FIG. 1 is a schematic diagram in which a rotating shaft mechanism provided in an embodiment in the embodiments of this application is applied to an electronic device, FIG. 2 is a schematic exploded view of the electronic device shown in FIG. 1, and FIG. 3 is a partial schematic diagram existing after a rotating shaft mechanism and a main body portion in FIG. 2 are assembled. A central axis X is marked in FIG. 2, and a horizontal centerline Y is marked in FIG. 3.

The electronic device provided in the embodiments of this application includes a flexible screen 300, main body portions 200, and a rotating shaft mechanism 100. There are two main body portions 200. The two main body portions 200 are connected through the rotating shaft mechanism 100. The two main body portions 200 can be folded or unfolded relative to each other by using the rotating shaft mechanism 100. For a mobile phone, the main body portion 200 may be a middle frame. The main body portion 200 is determined based on a terminal with a foldable screen, and is not specifically limited in this specification. The following further describes technical solutions and technical effects by using the middle frame as the main body portion 200.

At least a part of the flexible screen 300 can be supported on the middle frame and connected to the middle frame. In a process in which the two middle frames are folded or unfolded relative to each other, the flexible screen 300 is also in a folded state or an unfolded state. Structures of left and right middle frames may be the same, or may not be completely the same. Specific structures of the two middle frames may be stable based on a specific product, and are not specifically limited in this specification.

The flexible screen 300 may include a display module and a transparent cover plate. The display module can display an image, a video, and the like. The display module may include structural layers such as a touch control screen, a light-emitting layer, a backplane layer, and a substrate layer. A specific structure of the display module may be selected based on different products. The display module may be a liquid crystal display (liquid crystal display, LCD), an organic light-emitting diode (organic light-emitting diode, OLED), an active-matrix organic light emitting diode (active-matrix organic light emitting diode, AMOLED), a flexible light-emitting diode (flex light-emitting diode, FLED), a quantum dot light emitting diode (quantum dot light emitting diodes, QLED), or the like. The transparent cover plate covers an outer side of the display module to protect the display module. The transparent cover plate may be a glass cover plate, or may be of another transparent material that can provide a protection function.

Referring to FIG. 3, the rotating shaft mechanism 100 in this embodiment of this application includes a pedestal (not marked in the figure) and a synchronization mechanism. A in FIG. 3 is a mounting position of the synchronization mechanism. The pedestal mainly provides a mounting foundation for other components that constitute the rotating shaft mechanism. The pedestal may be of an integral structure, or certainly, may be of a split-type structure. To be specific, the pedestal may be split into a plurality of components, and the plurality of components are fixedly connected in a manner of using a fastener (for example, a screw), performing glue dispensing, performing welding, or the like. Generally, the rotating shaft mechanism further includes a shaft cover, and the shaft cover is located on a side that is of the pedestal and that is away from the flexible screen, to block the other components of the rotating shaft mechanism and improve appearance aesthetics of the electronic device.

The synchronization mechanism of the rotating shaft mechanism 100 in this embodiment of this application is configured to enable the main body portions 200 on two sides to synchronously rotate relative to the pedestal during folding or unfolding. Certainly, included angles of rotation between the main body portions 200 on the two sides relative to the pedestal theoretically keep consistent under an action of the synchronization mechanism. However, it may be understood that due to a deviation in assembly or processing, a specific angle deviation may be allowed for the two included angles of rotation between the main body portions 200 on the two sides relative to the pedestal during rotation, in other words, it may still be considered that the two main body portions synchronously rotate when the angle deviation range is not exceeded.

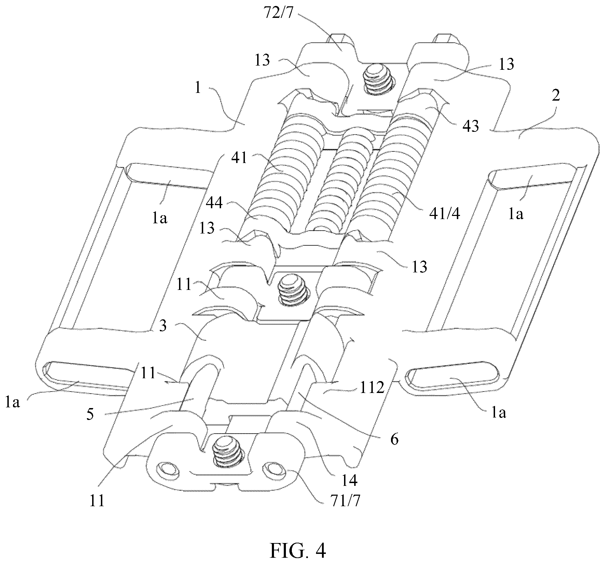

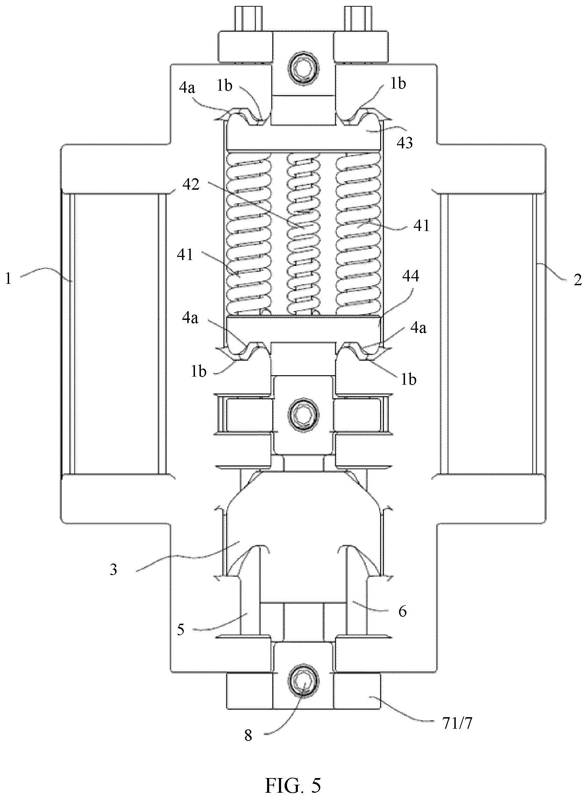

Refer to FIG. 4 and FIG. 5. FIG. 4 is a three-dimensional schematic diagram of a synchronization mechanism according to a first example of the embodiments of this application, and FIG. 5 is a front view of the synchronization mechanism in FIG. 4.

In this embodiment of this application, the synchronization mechanism includes a base 7, a slider 3, a first swing arm 1, a first rotating shaft 5, a second rotating shaft 6, the first swing arm 1, and a second swing arm 2. The base 7 and the foregoing pedestal may be of an integral structure, in other words, the base 7 is a part of the pedestal. Certainly, the base 7 and the pedestal may alternatively be two independent components, and are fixedly connected to each other by using a fastener or in another fastening manner (for example, through welding or screwing). It can be learned from FIG. 2 and FIG. 3 that two synchronization mechanisms are disposed in the rotating shaft mechanism 100, and are respectively close to two axial end portions of the rotating shaft mechanism 100. Certainly, a quantity of synchronization mechanisms may be properly selected based on different electronic devices, and is not limited to the descriptions in this specification. In other words, the rotating shaft mechanism may alternatively include two or more synchronization mechanisms. Referring to FIG. 3, two synchronization mechanisms are disposed in the rotating shaft mechanism in this embodiment of this application. The two synchronization mechanisms are symmetrically disposed with respect to the horizontal centerline Y. In addition to the synchronization mechanism, the rotating shaft mechanism in this embodiment of this application further includes two end-portion main swing arms 9 and a middle main swing arm 10. The two end-portion main swing arms 9 are adjacent to the two synchronization mechanisms, and the two end-portion main swing arms 9 are also symmetrically disposed with respect to the horizontal centerline Y.

The first rotating shaft 5 and the second rotating shaft 6 of the synchronization mechanism are disposed on the base 7 in parallel, and length directions of the first rotating shaft 5 and the second rotating shaft 6 are parallel to an axial direction of the rotation mechanism. The first rotating shaft 5 and the second rotating shaft 6 may be fixedly connected to the base 7, or certainly may be rotatably connected to the base 7. In an example, the base 7 includes a first mounting block 71 and a second mounting block 72. The first mounting block 71 and the second mounting block 72 are respectively located on two axial end portions of the base 7. The first mounting block 71 and the second mounting block 72 each are provided with a mounting hole, and the first rotating shaft 5 and the second rotating shaft 6 are inserted into the mounting holes mounted in the first mounting block 71 and the second mounting block 72. In this embodiment of this application, four corner portions of the first mounting block 71 each have a sleeve structure 711, and an inner hole of the sleeve structure 711 forms the mounting hole. In an example, the first rotating shaft 5 and the second rotating shaft 6 may be axially limited relative to the base 7 by using a limiting member, and the limiting member may be a component such as a screw cap or a locking pin.

The first swing arm 1 and the second swing arm 2 in this embodiment of this application are respectively sleeved on the first rotating shaft 5 and the second rotating shaft 6. The first swing arm 1 may rotate around the first rotating shaft 5 relative to the base 7, and the second swing arm 2 may rotate relative to the second rotating shaft 6. Both the first swing arm 1 and the second swing arm 2 are bilaterally symmetrically disposed with respect to the center axis X of the pedestal, and the first rotating shaft 5 and the second rotating shaft 6 are respectively located on left and right sides of the center axis X. Structures of the first swing arm 1 and the second swing arm 2 may be the same, or certainly may be different.

It should be noted that in this specification, a direction of approaching the central axis X is defined as "inward", and correspondingly, a direction of getting away from the central axis is defined as "outward".

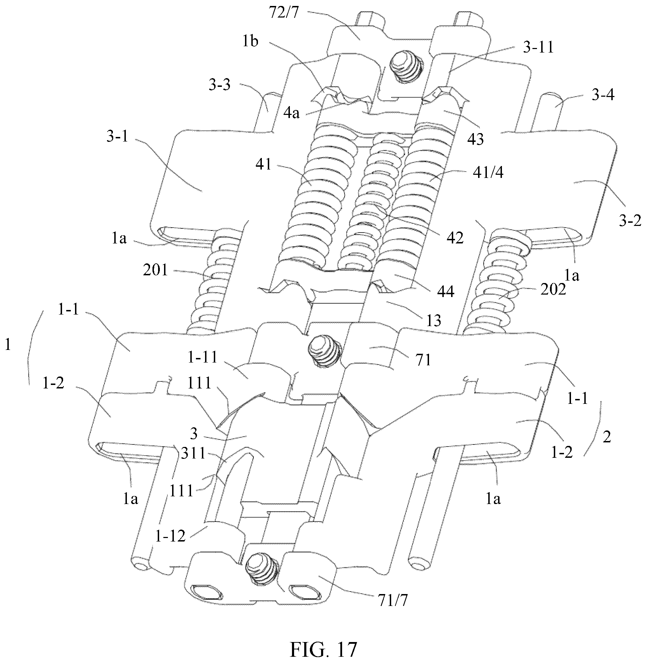

The first swing arm 1 and the second swing arm 2 are respectively connected to the main body portions on the two sides. For example, the first swing arm 1 and the second swing arm 2 may be swing arms fastened to the main body portions, to drive the main body portions on the two sides to be folded or unfolded relative to each other. In this embodiment of this application, a swing arm fixedly connected to the main body portion is defined as a main swing arm. Certainly, the first swing arm 1 and the second swing arm 2 may alternatively be relatively movably connected to the main body portions. For example, non-hinged ends of the first swing arm 1 and the second swing arm 2 are not directly fastened to the main body portions, and during rotation, the first swing arm 1 and the second swing arm 2 may slide relative to the main body portions. In this embodiment of this application, such a swing arm is defined as an auxiliary swing arm. As shown in FIG. 4, the first swing arm 1 and the second swing arm 2 each may be provided with an oblong through hole 1a, a shaft body (which is not shown in FIG. 4, and may be understood with reference to FIG. 17) is fastened to the main swing arm, and the shaft body is inserted into the oblong through hole 1a. During rotation of the main body portion and the main swing arm, the first swing arm 1 and the second swing arm 2 correspondingly rotate and slide with the shaft body in a length direction of the oblong through hole 1a. For example, a shaft body may be fastened to the end-portion main swing arm 9, to drive a swing arm in a synchronization mechanism adjacent to the end-portion main swing arm 9 to establish linkage.

Generally, driven by the swing arms, the main body portions on the two sides may rotate back and forth from 0° to 90°. When an included angle between the swing arm and a horizontal plane is 0°, the main body portion is roughly in a horizontal state, and the flexible screen 300 may be in a fully unfolded state. In this case, the flexible screen 300 is roughly in a horizontal state as a whole. When the included angle between the swing arm and the horizontal plane is 90°, the main body portions on the two sides are driven to rotate to a vertical state, and the flexible screen 300 is in a folded state.

In this embodiment of this application, a specific connection manner between the first swing arm 1 and the second swing arm 2 of the synchronization mechanism and the main body portions is not limited, provided that the first swing arm 1 and the second swing arm 2 are in linkage with the middle frame. For example, the shaft body may be fastened to the auxiliary swing arm, and the main swing arm is provided with the oblong through hole 1a, or the main swing arm and the auxiliary swing arm establish linkage through fitting of a protrusion and a recess or the like. In this embodiment of this application, the slider 3 in the synchronization mechanism can move in the axial direction of the rotating shaft mechanism, in other words, the slider 3 can move only axially relative to the base 7.

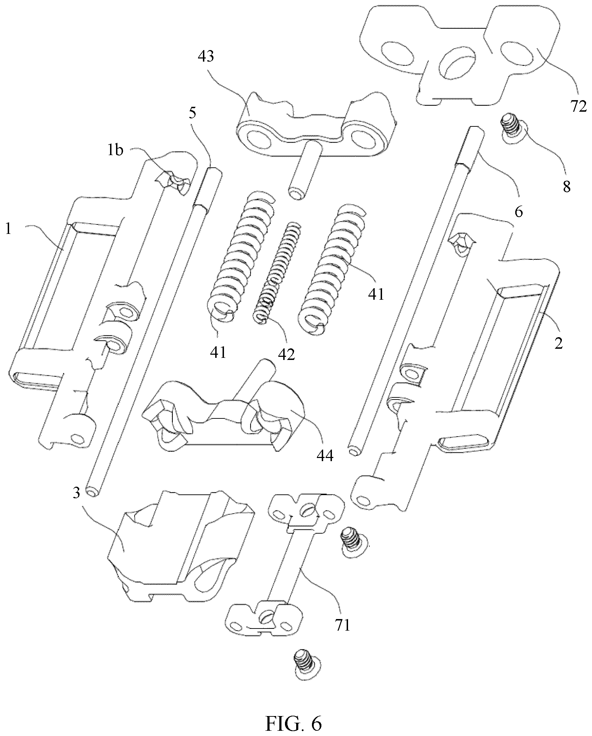

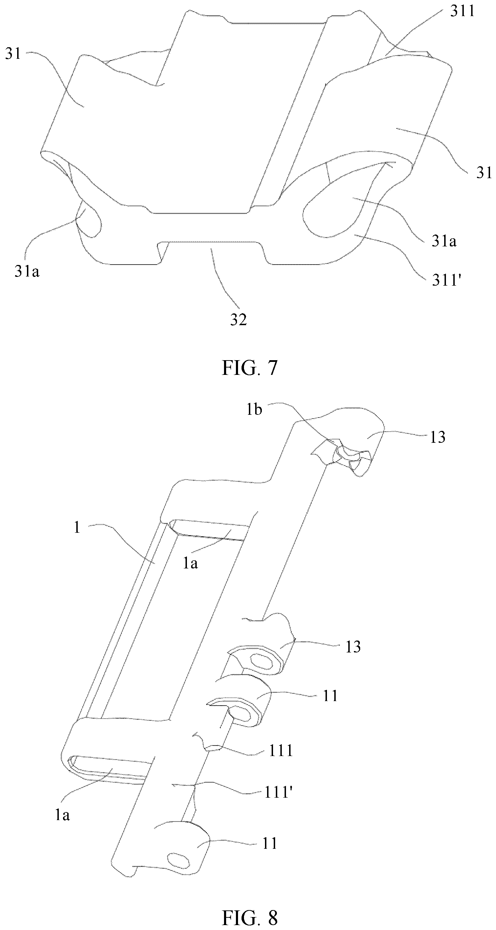

Refer to FIG. 6 and FIG. 7. FIG. 6 is a schematic exploded view of the synchronization mechanism shown in FIG. 4, and FIG. 7 is a three-dimensional schematic diagram of the slider in FIG. 4.

In this embodiment of this application, a first sleeve 31 having an inner hole 31a is included on each of two sides of the slider 3, the first rotating shaft 5 and the second rotating shaft 6 respectively pass through the first sleeves 31 on the left and right sides of the slider 3, and the slider 3 can move only in an axial direction of the first rotating shaft 5 and the second rotating shaft 6.

In this embodiment of this application, a protruding portion is disposed on each of the first swing arm 1 and the second swing arm 2. There may be two or more protruding portions. The protruding portion may be provided with a via hole for the first rotating shaft 5 or the second rotating shaft 6 to pass through. In other words, the first swing arm 1 and the second swing arm 2 are sleeved on the corresponding rotating shafts by using the protruding portions disposed on the first swing arm 1 and the second swing arm 2.

Referring to FIG. 4, in this application, there are four protruding portions on each of the first swing arm 1 and the second swing arm 2. The protruding portions are axially arranged at intervals. Based on different functions of the protruding portions, in this specification, the four protruding portions are defined as two first protruding portions 11 and two third protruding portions 13. The two first protruding portions 11 are adjacent to each other and are close to a lower part, and the two third protruding portions 13 are adjacent to each other and are close to an upper part. The slider 3 is located between two first protruding portions 11. An abutting portion is disposed on each of opposite end surfaces of the two first protruding portions 11, and a helical surface that fits with the abutting portion on a corresponding side is disposed on each of two end surfaces of the slider 3. Synchronous rotation between the first swing arm 1 and the second swing arm 2 on the left and right sides can be implemented through fitting of the helical surfaces and the abutting portions. Theoretically, the helical surfaces on the two end surfaces of the slider 3 and the abutting portions on the corresponding sides are always in an abutting state. Limited by a stroke of the slider 3, the helical surface may be only a small helical structure, and a projection in a plane perpendicular to the axial direction may be a ring-shaped structure. A central angle of the ring-shaped structure may range from 0 (excluding an endpoint value) to 360 degrees (including an endpoint value). FIG. 7 shows a specific example in which the central angle of the ring-shaped structure is approximately 180 degrees. Processing of the ring-shaped structure in a range of 0 to 180 degrees is relatively easy. Certainly, the central angle of the ring-shaped structure is not limited to those shown in this specification, and may be any value from 0 to 360 degrees.

Certainly, a quantity of protruding portions is not limited to 4 described above in this specification, and may be another quantity.

It may be understood from the foregoing descriptions that compared with a helical groove disposed on a main body between two end surfaces of a slider 3, in this embodiment of this application, the helical surface is formed on the end surface of the slider 3, and the helical surface has no undercut structure, and may be directly formed by using a mold or formed through conventional numerical control processing. The formation technology is relatively simple. In addition, in a manner in which the helical surface and the abutting portion fit with each other to implement axial sliding, relatively small space is occupied in a thickness direction of a mobile phone, and therefore, a thin and light design requirement of the electronic device such as a mobile phone is met.

The foregoing provides a specific example in which the helical surface is disposed on the end surface of the slider 3. A person skilled in the art should understand that the foregoing technical effect can also be achieved by disposing a helical surface on the end surface of the first protruding portion 11 and disposing an abutting portion on the end surface of the slider 3. In other words, it is only necessary to dispose a helical surface on an end surface of one of the first protruding portion 11 and the slider 3 and dispose, on an end surface of the other one of the first protruding portion 11 and the slider 3, an abutting portion that fits with the helical surface.

The following describes several specific examples by using an example in which the helical surface is disposed on the slider 3.

Refer to FIG. 4, FIG. 7, and FIG. 8 for understanding. FIG. 8 is a three-dimensional schematic diagram of the first swing arm 1 in FIG. 4. In the first example, each of two end surfaces of a first sleeve 31 on each of the two sides of the slider 3 has a helical surface, there are two first protruding portions 11, the two first protruding portions 11 are axially spaced apart, and the two first protruding portions 11 have coaxial via holes. The first rotating shaft 5 passes through a via hole of the first protruding portion 11 on the first swing arm 1 on the left side, and the second rotating shaft 6 passes through a via hole of the first protruding portion 11 on the second swing arm 2 on the right side. A first abutting portion 111 and a second abutting portion 111' are disposed on opposite surfaces of the two first protruding portions 11, and are respectively configured to fit with and abut against the helical surfaces on the two end surfaces of the first sleeve 31. As shown in FIG. 7 and FIG. 8, a first helical surface 311 on an upper end surface of the slider 3 abuts against and fits with the first abutting portion 111 disposed on the end surface of the first protruding portion 11, and a second helical surface 311' on a lower end surface of the slider 3 abuts against and fits with the second abutting portion 111' disposed on an end surface of the other first protruding portion 11.

The first swing arm 1 and the second swing arm 2 synchronously rotate through fitting of the first helical surface 311 and the first abutting portion 111 and fitting of the second helical surface 311' and the second abutting portion 111', and stability is relatively high.

Theoretically, to enable the first helical surface 311 and the first abutting portion 111, and the second helical surface 311' and the second abutting portion 111' to keep abutting against each other, a spacing between the first abutting portion 111 and the second abutting portion 111' is approximately equal to a spacing between the first helical surface 311 and the second helical surface 311'. In other words, a spacing between helical surfaces located on two end surfaces of a same first sleeve 31 is approximately equal to a spacing between the first abutting portion and the second abutting portion.

Due to factors such as a processing error and an assembly tolerance, the helical surface and the abutting portion may be unable to abut against each other during rotation after the synchronization mechanism is assembled. Therefore, the following setting is further performed in this embodiment of this application.

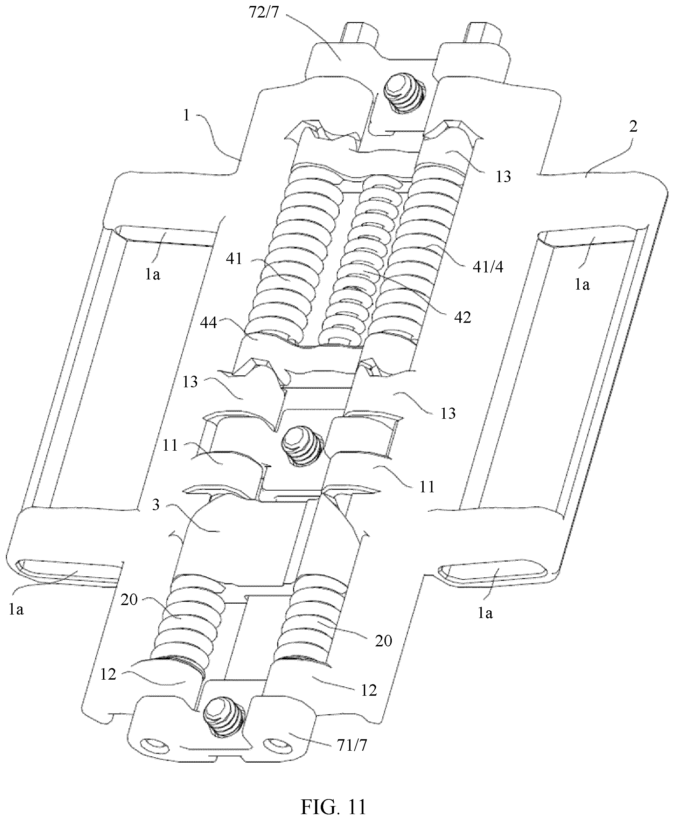

Referring to FIG. 11, FIG. 14, and FIG. 15, the synchronization mechanism in this embodiment of this application further includes an elastic component 20. Under an action of a restoring force of the elastic component 20, the helical surface and the abutting portion elastically abut against each other, in other words, the elastic component 20 is axially in a compressed state. In this way, the elastic component can enable the helical surface and the abutting portion to be always in an abutting state during rotation of the swing arms, so that rotation synchronization of the swing arms on the two sides is improved.

The elastic component 20 may be a spring, or may be another component with elasticity, for example, silicone or a rubber. As shown in FIG. 4, there may be two elastic components, and the two elastic components 20 may be respectively sleeved on the first rotating shaft 5 and the second rotating shaft 6. Certainly, there may be one elastic component or another quantity of elastic components.

Based on different mounting positions of the elastic component, the embodiments of this application provide a second specific example.

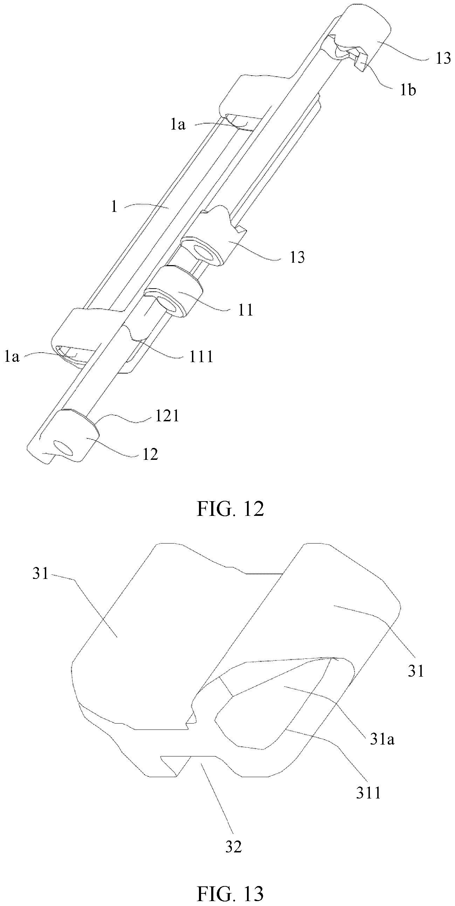

Refer to FIG. 11, FIG. 12, and FIG. 13. FIG. 11 is a three-dimensional schematic diagram of a synchronization mechanism according to the second example of the embodiments of this application, FIG. 12 is a three-dimensional schematic diagram of a first swing arm in FIG. 11, and FIG. 13 is a three-dimensional schematic diagram of a slider in FIG. 11.

In the second example, a helical surface is disposed only on one end surface of the slider 3, and correspondingly, there is also one first protruding portion 11 on each of the first swing arm 1 and a second swing arm 2, and an abutting portion is disposed on an end surface of the first protruding portion 11. To help mount an elastic component, second protruding portions 12 are further disposed on the first swing arm 1 and the second swing arm 2, and the second protruding portion 12 and the first protruding portion 11 are spaced apart. The elastic component 20 is press-fitted between the slider 3 and the second protruding portion 12. Specifically, the elastic component may be press-fitted between the other end surface of the slider 3 and the second protruding portion 12. Specifically, the end surface that is of the slider 3 and that is opposite to the second protruding portion 12 may be of a planar structure. Certainly, a structure such as an elastic component mounting base may be further disposed.

In this embodiment, the helical surface is processed only on one end portion of the slider 3. The structure is relatively simple, and occupies relatively small axial space.

The second protruding portion 12 may also be provided with a via hole that is coaxial with that of the first protruding portion 11, for a rotating shaft on a corresponding side to pass through. In this way, the protruding portions are mounted fittingly with the rotating shafts, so that mounting strength of the swing arms can be improved.

To further improve rotation flexibility of the rotating shaft mechanism, the following improvements are further made to the synchronization mechanism in the embodiments of this application.

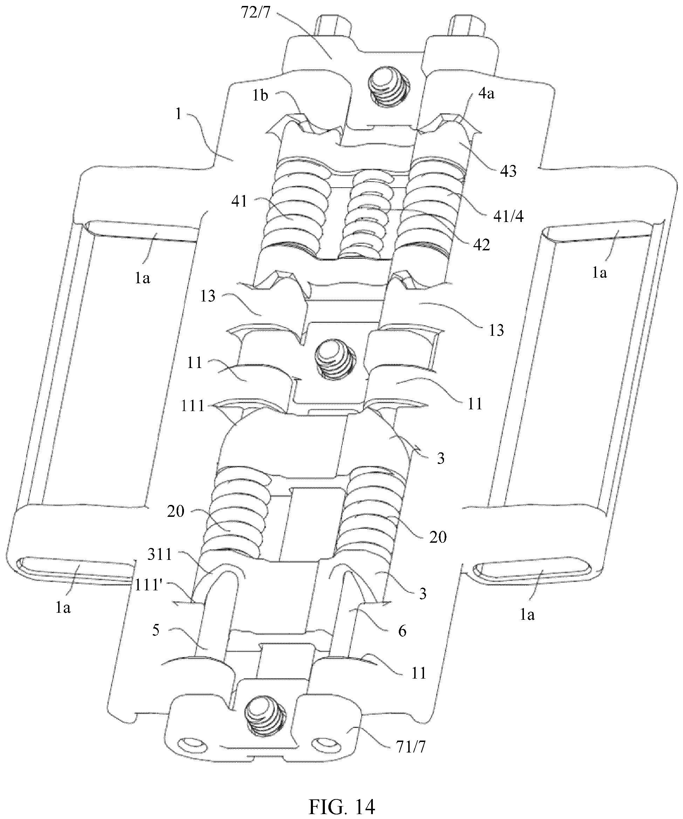

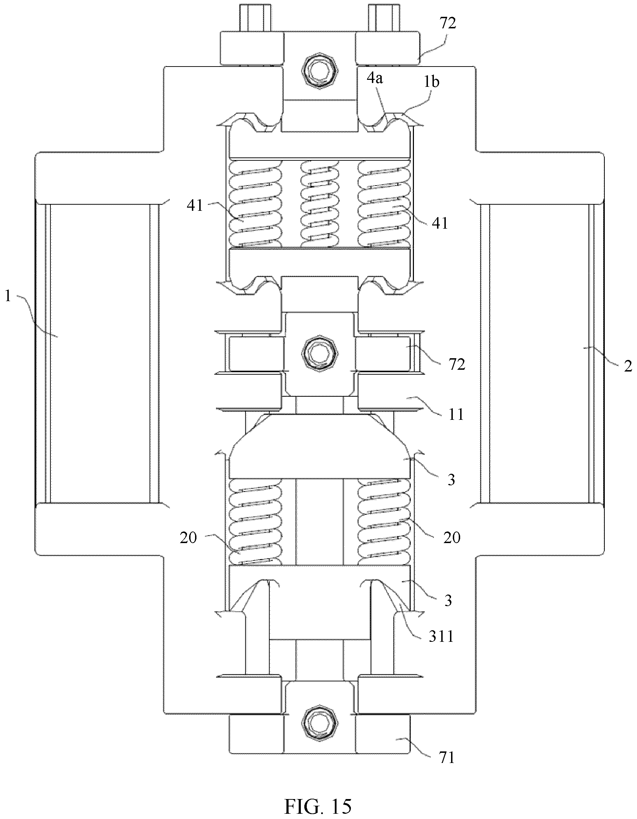

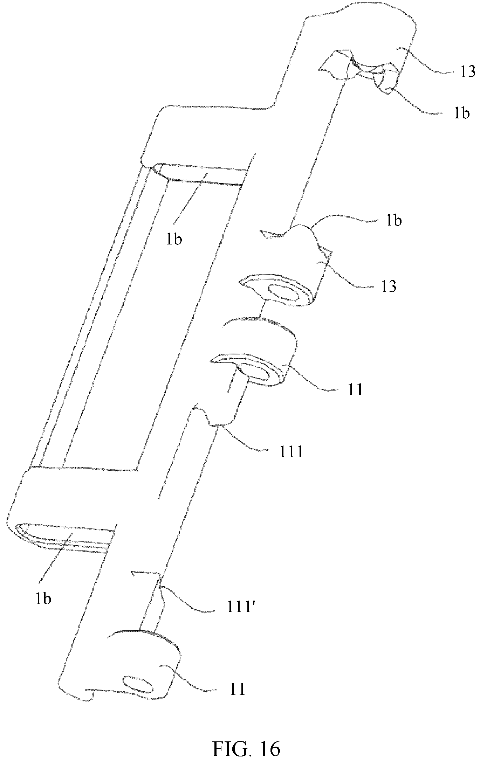

Refer to FIG. 14 to FIG. 16. FIG. 14 is a three-dimensional schematic diagram of a synchronization mechanism according to a third example of the embodiments of this application, FIG. 15 is a schematic front view of FIG. 14, and FIG. 16 is a three-dimensional schematic diagram of a first swing arm in FIG. 14.

In the third example, a slider 3 of the synchronization mechanism includes a first slider and a second slider. An elastic component 20 is press-fitted between the first slider and the second slider. A helical surface is disposed on each of end surfaces that are of the first slider and the second slider and that are relatively away from each other. In this example, a structure of the slider 3 is the same as that of the slider 3 in the second example. Differently, in this example, two sliders 3 are disposed, and the elastic component is press-fitted between the two sliders 3. Correspondingly, two first protruding portions 11 that are spaced apart are disposed on each of the first swing arm 1 and a second swing arm 2, and an abutting portion is disposed on each of two opposite surfaces of the two first protruding portions 11. In this example, structures of the first swing arm 1 and the second swing arm 2 are approximately the same as structures of the first swing arm 1 and the second swing arm 2 in the first example, and a spacing between the two first protruding portions 11 may also be slightly different.

Under an action of a restoring force of the elastic component, the helical surface of the slider 3 on each of two sides of the elastic component can always abut against an abutting portion of a first protruding portion 11 on a corresponding side.

Similarly, in this example, there are also two elastic components, and the two elastic components are respectively sleeved on a first rotating shaft 5 and a second rotating shaft 6 on two sides.

The foregoing three embodiments only differ in a fitting position and structure between the slider 3 and the swing arm (the first swing arm 1 or the second swing arm 2), and other structures of the synchronization mechanism may be approximately the same.

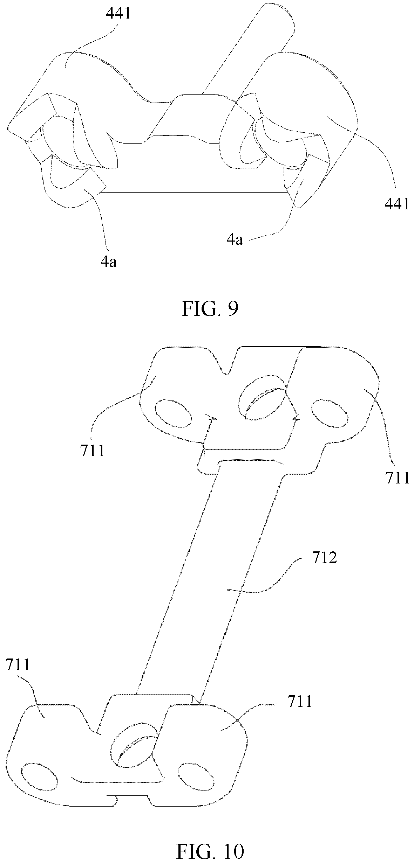

Further referring to FIG. 6 and FIG. 10, a guide rail 712 is disposed on a base 7 of the synchronization mechanism in this embodiment of this application. For example, the guide rail 712 is disposed on a first mounting block 71. A recess 32 is disposed on the slider 3. Both the guide rail 712 and the recess axially extend, and the guide rail 712 and the recess 32 are axially in sliding fit with each other. In this way, the guide rail and the recess further guide an axial movement of the slider 3, and also improves sliding stability of the slider 3.

Certainly, the foregoing technical effect can also be achieved by disposing a recess on the base 7 and disposing, on the slider 3, a guide rail that fits with the recess.

To improve a hand feel during folding or unfolding of the electronic device, a damping apparatus 4 may be further disposed on the synchronization mechanism, to provide rotation damping for the first swing arm 1 and the second swing arm 2. The damping apparatus 4 is directly mounted between the first swing arm 1 and the second swing arm 2. Certainly, the damping apparatus 4 may alternatively be indirectly connected to the first swing arm 1 and the second swing arm 2.

In this embodiment of this application, the damping apparatus 4 includes an elastic damping component that is circumferentially limited by the base 7 and that is capable of axially extending or retracting. In other words, the elastic damping component can axially extend or retract, but circumferentially, the elastic damping component is limited by the base 7, and the elastic damping component and the base 7 cannot rotate relative to each other. The first swing arm 1 and the second swing arm 2 each have a first concave-convex surface, and the elastic damping component has second concave-convex surfaces that are in a one-to-one correspondence with the first concave-convex surfaces and that elastically abut against the first concave-convex surfaces. Both the first concave-convex surface 1b and the second concave-convex surface 4a are wavy surfaces with smooth circumferential transition, and a degree of fluctuation between a concave surface and a convex surface of the wavy surface may be properly selected based on a damping magnitude required by the electronic device. During rotation of the first swing arm 1 and the second swing arm 2, the first concave-convex surface 1b slides relative to the second concave-convex surface, and a friction force generated when the first concave-convex surface and the second concave-convex surface elastically abut against each other can provide rotation damping. When relatively high points of the first concave-convex surface 1b and the second concave-convex surface come into contact with each other, the friction force is relatively large, and a hover function can be implemented.

In this embodiment of this application, two third protruding portions 13 that are spaced apart are disposed on each of the first swing arm 1 and the second swing arm 2, and the third protruding portion 13 is provided with a via hole for a rotating shaft on a corresponding side to pass through. The first rotating shaft 5 passes through a via hole of a third protruding portion 13 of the first swing arm 1 on a left side, and the second rotating shaft 6 is located in a via hole of a third protruding portions 13 of the second swing arm 2 on a right side. With reference to the foregoing descriptions, the first rotating shaft 5 is disposed inside via holes of protruding portions (the first protruding portion 11, the second protruding portion 12, and the third protruding portion 13) on a same side, to implement a rotary connection to the base 7. A first concave-convex surfaces 1b is disposed on each of two opposite surfaces of the third protruding portions 13, in other words, the third protruding portion 13 is also of a sleeve structure. The sleeve structure is defined as a third sleeve in this specification. A first concave-convex surface 1b is disposed on an end surface of the third sleeve. In this embodiment, the first concave-convex surface 1b and the rotating shaft are coaxially disposed, and the structure is compact.

Referring to FIG. 9, correspondingly, there may also be a sleeve structure on each of four end portions of the elastic damping component. The sleeve structure is defined as a second sleeve 441 in this specification. A second concave-convex surface is disposed on an end portion that is of the third sleeve and that corresponds to the second sleeve 441. In this embodiment, the elastic damping component includes a first bracket 43, a second bracket 44, and a first elastic member 41. The first elastic member 41 is press-fitted between the first bracket 43 and the second bracket 44. A second sleeve 441 having a through hole 4a exists on each of two sides of each of the first bracket 43 and the second bracket 44, and the second sleeves 441 on the two sides are respectively sleeved on the first rotating shaft 5 and the second rotating shaft 6. In other words, the first bracket 43 (the second bracket 44) is sleeved on both the first rotating shaft 5 and the second rotating shaft 6. In this way, the first bracket 43 (the second bracket 44) cannot rotate relative to the base 7, but can slide in an axial direction of the first rotating shaft 5 and the second rotating shaft 6.

To simplify processing and improve assembly efficiency, the first bracket 43 and the second bracket 44 may be of a same structure.

When the first swing arm 1 and the second swing arm 2 on the two sides rotate at the same time, the first concave-convex surfaces 1b on the two swing arms rotate relative to the second concave-convex surfaces 4a of the sleeves on the two sides, and provide rotation damping for the first swing arm 1 and the second swing arm 2, to improve a hand feel of using the electronic device while implementing synchronous rotation between the first swing arm 1 and the second swing arm 2.

In this embodiment of this application, there may be two first elastic members 41. The two elastic members are respectively sleeved on the first rotating shaft 5 and the second rotating shaft 6. A second concave-convex surface is disposed on an end portion that is of each second sleeve 441 and that is away from the first elastic member 41. The first rotating shaft 5 and the second rotating shaft 6 can guide extension or retraction of the two first elastic members 41.

Certainly, there may alternatively be one or more first elastic members 41.

Generally, a larger elastic abutment force between the first concave-convex surface 1b and the second concave-convex surface 4a indicates larger corresponding rotation damping. To improve rotation damping of the damping apparatus 4, a second elastic member 42 may be further added. The second elastic member 42 may be disposed between the two first elastic members 41. In addition, a support for mounting the second elastic member 42 may be further disposed on each of opposite side surfaces of the first bracket 43 and the second bracket 44. As shown in FIG. 9, a guide rod is disposed on each of the first support 43 and the second support 44, and the second elastic member 42 is sleeved on the guide rod.

Both the first elastic member 41 and the second elastic member 42 may be springs.

The foregoing third example describes a specific implementation in which the slider 3 is divided into the first slider 3 and the second slider 3 to implement elastic abutment between the helical surface and the abutting portion. Certainly, it is also feasible that the first swing arm 1 and the second swing arm 2 each are divided into two parts to implement elastic abutment between the helical surface and the abutting portion.

In the foregoing examples, the damping apparatus may be disposed between the first swing arm 1 and the second swing arm 2, or certainly may be disposed separately, and is disposed between other swing arms of the rotating shaft mechanism, in other words, is relatively independent of the synchronization mechanism, as shown in FIG. 17.

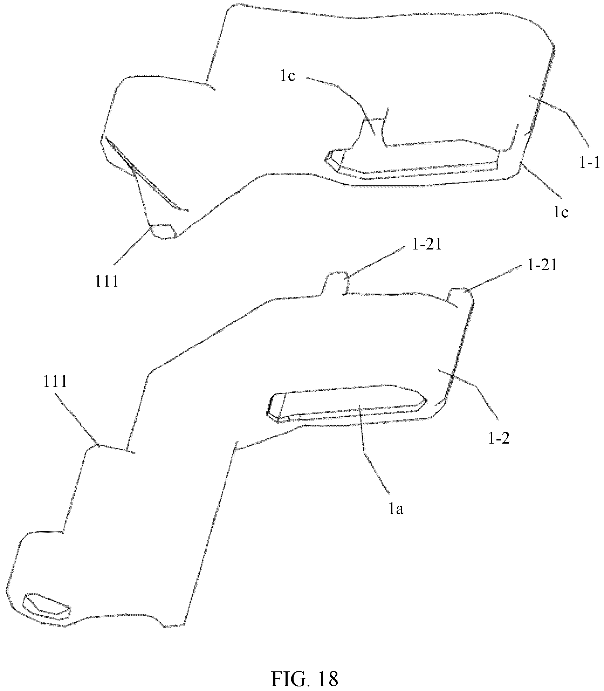

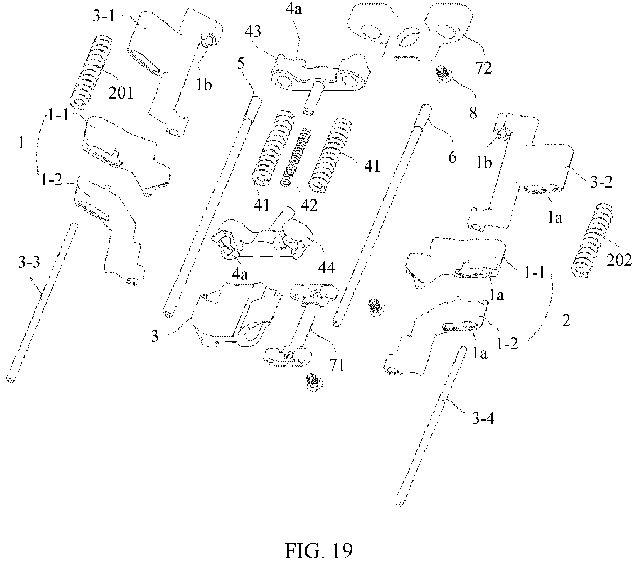

Refer to FIG. 17 to FIG. 19. FIG. 17 is a three-dimensional schematic diagram of a synchronization mechanism according to a fourth example of the embodiments of this application, FIG. 18 is a schematic exploded view of a first swing sub-arm 1-1 and a second swing sub-arm 1-2 in FIG. 17, and FIG. 19 is a schematic exploded view of the synchronization mechanism shown in FIG. 17.

In the fourth example, a first swing arm 1 and a second swing arm 2 each include a first swing sub-arm 1-1 and a second swing sub-arm 1-2 that can be axially separated relative to each other. The first swing sub-arm 1-1 and the second swing sub-arm 1-2 are two independent components, and can axially move relative to each other. An amount of movement may be determined based on an actual electronic device. In addition, the first swing sub-arm 1-1 and the second swing sub-arm 1-2 are circumferentially limited, so that the first swing sub-arm 1-1 and the second swing sub-arm 1-2 synchronously rotate. The first swing sub-arm 1-1 and the second swing sub-arm 1-2 cannot rotate relative to each other through limitation of limiting members. The limiting members may be recess and protrusion structures. For example, a recess 1c may be disposed on one of the first swing sub-arm 1-1 and the second swing sub-arm 1-2, and a protrusion 1-21 inserted into the recess 1c is disposed on the other one of the first swing sub-arm 1-1 and the second swing sub-arm 1-2 to limit circumferential rotation of the first swing sub-arm 1-1 and the second swing sub-arm 1-2. The recess 1c and the protrusion 1-21 may be disposed at non-hinged ends of the first swing sub-arm 1-1 and the second swing sub-arm 1-2. Certainly, a circumferential limiting manner of the first swing sub-arm 1-1 and the second swing sub-arm 1-2 is not limited to the foregoing manner, and may alternatively be another manner, for example, buckling.

The first swing sub-arm 1-1 and the second swing sub-arm 1-2 each have a protruding portion. In this example, a protruding portion of the first swing sub-arm 1-1 is defined as a protruding portion A1-11, and a protruding portion of the second swing sub-arm 1-2 is defined as a protruding portion B1-12. The foregoing definitions are merely for clarity and brevity of the descriptions of the technical solution. Structures of the protruding portion A1-11 and the protruding portion B1-12 may be the same as that of the first protruding portion 11 in the foregoing first example to third example. Unlike the first example in which the two first protruding portions 11 that fit with and abut against the slider 3 are located on a same swing arm, in this example, the protruding portions that fit with and abut against the slider 3 are located on two swing sub-arms. The slider 3 is located between a protruding portion A1-11 and a protruding portion B1-12 on a same side. Under an action of an elastic component, two axially arranged end surfaces of the slider 3 respectively elastically abut against the protruding portion A1-11 and the protruding portion B1-12.

Certainly, end surface shapes of the protruding portion A1-11 and the protruding portion B1-12 may be in a plurality of forms, provided that the protruding portion A1-11 and the protruding portion B1-12 can fit with and abut against the slider 3.

The slider 3 is located between the protrusion portion A1-11 and the protrusion portion B1-12. A helical surface may be disposed on the end surface of the slider 3. The protrusion portion A1-11 and the protrusion portion B1-12 each have a smooth surface, for example, a helical surface of a small length or a curved surface, that can slide along the helical surface. The figure shows that a helical surface is disposed on each of the two end surfaces of the slider 3, and an abutting portion is disposed on each of corresponding end surfaces of the protrusion portion A1-11 and the protrusion portion B1-12.

In this example, the first swing arm 1 and the second swing arm 2 are designed as being of a split-type structure. The first swing arm 1 and the second swing arm 2 each are divided into a first swing sub-arm 1-1 and a second swing sub-arm 1-2 that are relatively independent. The first swing sub-arm 1-1 and the second swing sub-arm 1-2 can axially get away from or approach each other. After the slider 3 is mounted in place, axial positions of the first swing sub-arm 1-1 and the second swing sub-arm 1-2 may be adjusted, so that the abutting portions and the helical surfaces are in an abutting state. In this way, the slider 3 can be easily mounted. In addition, designing one swing arm with two parts can also reduce a processing technology of the swing arm.

The foregoing describes an example in which the helical surface is disposed at each of two ends of the slider 3 and the protruding portion is disposed on each of the first swing sub-arm 1-1 and the second swing sub-arm 1-2. A person skilled in the art should understand that the foregoing technical effect can also be achieved by disposing a helical surface on one side of the slider 3 and disposing a protruding portion on only one of the first swing sub-arm 1-1 and the second swing sub-arm 1-2. Certainly, the foregoing technical effect can also be achieved by disposing abutting portions on the slider 3 and disposing, on the end surfaces of the protruding portions of the first swing sub-arm 1-1 and the second swing sub-arm 1-2, helical surfaces that fit with the abutting portions. Technical details are not described in this specification.

In this example, a first rotating shaft 5 and a second rotating shaft 6 may also be disposed on a base 7, the first rotating shaft 5 and the second rotating shaft 6 are disposed in parallel, the first swing arm 1 rotates around the first rotating shaft 5, the second swing arm 2 rotates around the second rotating shaft 6, and the slider 3 can slide along the first rotating shaft 5 and the second rotating shaft 6. This is the same as that in the foregoing several example structures.

To improve stability of the rotating shaft mechanism, a first swing sub-arm 1-1 and a second swing sub-arm 1-2 on a same side may be sleeved on a rotating shaft on a corresponding side. For example, a protruding portion A of the first swing sub-arm 1-1 and a protruding portion B of the second swing sub-arm 1-2 of the first swing arm 1 may be provided with coaxial via holes for the first rotating shaft 5 to pass through, and a protruding portion A of the first swing sub-arm 1-1 and a protruding portion B of the first swing sub-arm 1-2 of the second swing arm 2 may be provided with coaxial via holes for the second rotating shaft 6 to pass through.

In this example, a structure of the slider 3 may be the same as that in the first example. A first sleeve 31 is disposed on each of two sides of the slider 3, the first sleeves 31 on the two sides are respectively slidably sleeved on the first rotating shaft 5 and the second rotating shaft 6. Each of two end surfaces of each first sleeve 31 has a helical surface 311, and the helical surfaces 311 respectively fit with an abutting portion of a protruding portion A and an abutting portion of a protruding portion B on a corresponding side.

A length and a technical effect of the helical surface are the same as those in the foregoing examples, and are not described herein in detail.

On the basis of the fourth example, a mounting position of the elastic component may be in a plurality of forms. The following provides two different mounting manners.

Referring to FIG. 17 again, on the basis of the fourth example, the synchronization mechanism may further include a third swing arm 3-1 and a fourth swing arm 3-2. The third swing arm 3-1 and the fourth swing arm 3-2 are respectively rotatably connected to two sides of the base 7. The third swing arm 3-1 and the first swing arm 1 are located on a same side of the base 7, and are axially arranged in sequence. The fourth swing arm 3-2 and the second swing arm 2 are disposed on a same side, and the fourth swing arm 3-2 and the second swing arm 2 are axially arranged in sequence. An elastic component is press-fitted between the first swing arm 1 and the third swing arm 3-1, and an elastic component is press-fitted between the fourth swing arm 3-2 and the second swing arm 2. The elastic components may be mounted at non-hinged ends away from hinged ends of the first swing arm 1 and the second swing arm 2.

The third swing arm 3-1 and the fourth swing arm 3-2 may be capable of being fixedly connected to the main body portions, in other words, used as main swing arms, or certainly, may be capable of sliding relative to the main body portions as auxiliary swing arms during rotation, provided that the third swing arm 3-1 and the fourth swing arm 3-2 can form a linkage mechanism with the main body portions.

As shown in FIG. 17, to enable swing arms on a same side of the base 7 to swing at a same angle relative to the base 7, in this embodiment of this application, the swing arms are each provided with an oblong through hole 1a. As shown in the figure, the first swing sub-arm 1-1, the second swing sub-arm 1-2, and the third swing arm 3-1 each are provided with an oblong through hole 1a, and a first shaft body 3-3 is disposed inside the oblong through holes 1a of the swing arms. When the main body portion rotates, the first shaft body 3-3 can slide inside the oblong through holes 1a to drive the swing arms to synchronously rotate. Similarly, an oblong through hole 1a and a second shaft body 3-4 located inside the oblong through hole 1a are also disposed on each of swing arms on a right side of the base 7, to coordinate same-angle swing of the swing arms.

Certainly, a hole disposed on each swing arm is not limited to the oblong through hole 1a, and may alternatively be of another structure. To be specific, a first hole is disposed on each of the swing arms on a left side, a second hole is disposed on each of the swing arms on the right side, and the first shaft body runs through the first holes to implement synchronous rotation between the swing arms on the left side, and the second shaft body runs through the second holes to implement synchronous rotation between the swing arms on the right side.

In this example, the elastic component includes a first elastic component 201 and a second elastic component 202, and the first elastic component 201 and the second elastic component 202 are respectively sleeved on the first shaft body 3-3 and the second shaft body 3-4. In this example, the first shaft body 3-3 and the second shaft body 3-4 can provide functions of mounting and guiding the two elastic components. The structure of the synchronization mechanism is relatively compact.

In addition, the first elastic component is located on an outer side of a rotating shaft of the first swing arm 1, two ends of the first elastic component are supported on non-rotary ends of the first swing arm 1 and the third swing arm 3-1, the second elastic component is located on an outer side of a rotating shaft of the second swing arm 2, and two ends of the second elastic component are supported on non-hinged ends of the second swing arm 2 and the fourth swing arm 3-2. The first elastic component and the second elastic component are disposed on outer end portions away from the rotating shafts of the swing arms, so that space is relatively large, and design flexibility is relatively high.

The first elastic component 201 may apply an elastic force toward the second swing sub-arm 1-2 to the first swing sub-arm 1-1 on the left side, to push the first swing sub-arm 1-1 to move toward the second swing sub-arm 1-2, so that an abutting portion (an upper abutting portion) of the first swing sub-arm 1-1 abuts and presses against the helical surface of the slider 3, the slider 3 moves toward the second swing sub-arm 1-2, and a helical surface at the other end of the slider 3 also comes into abutting contact with an abutting portion 111 (a lower abutting portion) of the second swing sub-arm 1-2.

Similarly, under an action of an elastic restoring force of the second elastic component, helical surfaces on two end surfaces on a right side of the slider 3 also come into abutting contact with corresponding abutting portions of the helical surfaces.

In this example, to improve a hand feel of folding or unfolding the electronic device, a damping apparatus 4 may also be disposed. A structure of the damping apparatus 4 may be the same as a structure of the damping apparatus 4 in the first example. The damping apparatus 4 may be mounted between two first swing sub-arms 1-1 or two second swing sub-arms 1-2 or between the third swing arm 3-1 and the fourth swing arm 3-2. FIG. 17 to FIG. 19 provide a specific structure in which the damping apparatus 4 is mounted between the third swing arm 3-1 and the fourth swing arm 3-2. The damping apparatus 4 includes an elastic damping component that is circumferentially limited by the base 7 and that is capable of axially extending or retracting, the third swing arm 3-1 and the fourth swing arm 3-2 each have a first concave-convex surface 1b, the elastic damping component has second concave-convex surfaces 4a that are in a one-to-one correspondence with the first concave-convex surfaces 1b and that elastically abut against the first concave-convex surfaces 1b, and when the third swing arm 3-1 and the fourth swing arm 3-2 rotate, the first concave-convex surface 1b rotates relative to the second concave-convex surface 4a to provide damping.

In this example, two protruding portions C3-11 that are axially spaced apart are disposed on each of the third swing arm 3-1 and the fourth swing arm 3-2, the protruding portion C3-11 is provided with a through hole for a rotating shaft on a corresponding side to pass through, and a first concave-convex surface 1b is disposed on each of two opposite surfaces of the two protruding portions C3-11.

The elastic damping component includes a first bracket 43, a second bracket 44, and a first elastic member 41, a second sleeve exists on each of two sides of each of the first bracket 43 and the second bracket 44, the two second sleeves are respectively sleeved on the first rotating shaft 5 and the second rotating shaft 6, the first elastic member 41 is press-fitted between the first bracket 43 and the second bracket 44, and a second concave-convex surface 4a is disposed on an end portion that is of each of the second sleeves and that is away from the first elastic member 41.

In another example, the elastic component and the elastic member of the damping apparatus 4 are designed as an integral structure. In other words, the elastic member in the damping apparatus 4 can provide a rotation damping function, and can also provide a function of enabling the abutting portion to abut against the helical surface. A specific structure of the synchronization structure is as follows.

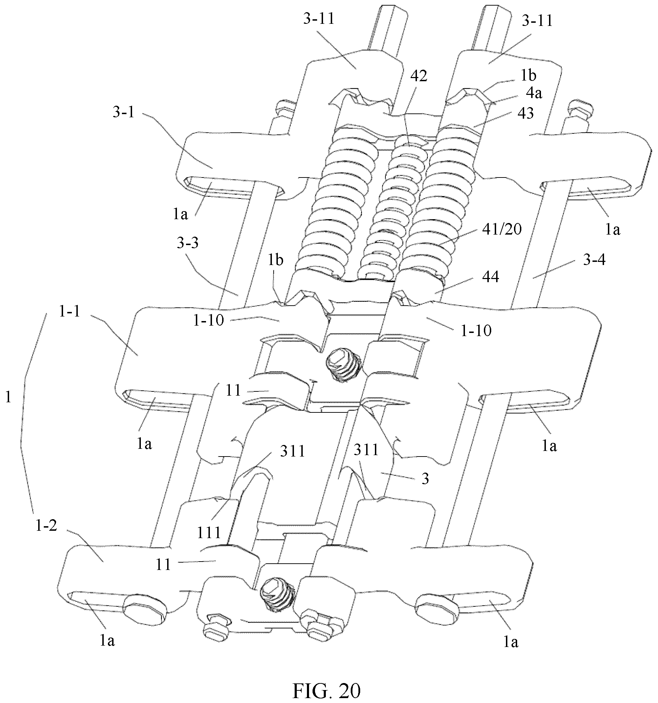

Refer to FIG. 20. FIG. 20 is a schematic diagram of a structure of a synchronization mechanism according to a fifth example of the embodiments of this application.

In the fifth example, an elastic component includes two first elastic members 41, the two first elastic members 41 are respectively sleeved on a first rotating shaft 5 and a second rotating shaft 6, the first elastic member 41 is circumferentially limited by a base 7, a second elastic member 42 is circumferentially limited by the base 7, and at least one end portion of each of the first elastic member 41 and the second elastic member 42 is capable of abutting against and fitting with a concave-convex surface of a swing arm on a corresponding side to provide rotation damping. FIG. 20 shows an example in which a sleeve 1-10 is disposed on a first swing sub-arm 1-1, and a concave-convex surface that fits with the elastic component in a concave-convex manner is disposed on the sleeve 1-10. In other words, the first elastic member 41 cannot circumferentially rotate relative to the base 7, and the second elastic member 42 cannot circumferentially rotate relative to the base 7, either. In this way, when swing arms rotate relative to the base 7, because the first elastic member 41 abuts against a concave-convex surface of a swing arm on at least one end, friction damping can be generated between the first elastic member 41 and the concave-convex surface, to meet a hand feel requirement of a user.

In this example, the elastic component includes a bracket, a second sleeve exists on each of two sides of the bracket, the two second sleeves are respectively sleeved on the first rotating shaft 5 and the second rotating shaft 6, and under an action of the elastic component, the two second sleeves elastically fit with concave-convex surfaces of swing arms corresponding to the two second sleeves to provide rotation damping. For a structure of the bracket, refer to structures of the first bracket 43 and the second bracket 44 in the foregoing examples.

The bracket includes a first bracket 43 and a second bracket 44 that are located at two ends of the elastic component, a first swing arm 1 and a second swing arm 2 respectively elastically abut against concave-convex surfaces of second sleeves on two sides of the first bracket 43, and a third swing arm 3-1 and a fourth swing arm 3-2 respectively elastically abut against concave-convex surfaces of second sleeves on two sides of the second bracket 44.

Certainly, to increase a damping force of the rotating shaft mechanism or a contact force between an abutting portion and a helical surface, the elastic component further includes the second elastic member 42, the second elastic member 42 is located between the two first elastic members 41, and a support for mounting the second elastic member 42 is further disposed on each of opposite side surfaces of the first support 43 and the second support 44. The support may be an axially extending guide rod, and the second elastic member 42 is sleeved on the guide rod.

Certainly, in this example, a first shaft body 3-3 and a second shaft body 3-4 are also disposed on the synchronization mechanism. The first shaft body 3-3 runs through non-hinged ends of swing arms on a left side of the base 7, and the second shaft body 3-4 runs through non-hinged ends of swing arms on a right side of the base 7. For the first shaft body 3-3, the second shaft body 3-4, and a structure in which the first shaft body and the second shaft body are mounted on the swing arms, refer to the foregoing descriptions.

A person skilled in the art should understand that manners of disposing the elastic component include but are not limited to the following two manners. For example, the elastic component may not be disposed on the first shaft body 3-3 or the second shaft body 3-4, a spring mounting base is additionally disposed on each of opposite end surfaces of the first swing sub-arm 1-1 and a second swing sub-arm 1-2, and the elastic component is mounted on the spring mounting base. Similarly, in this example, a guide rail 712 and a recess 32 may also be disposed on the base 7 and a slider 3 to further guide an axial movement of the slider 3.

The electronic device in the embodiments of this application includes the rotating shaft mechanism 100 in the foregoing embodiments, and therefore, also has the foregoing technical effects of the rotating shaft mechanism 100.

The principle and implementations of the embodiments of this application are described in the embodiments of this application by using specific examples. The descriptions of the foregoing embodiments are merely used for helping understand the method and core ideas of the embodiments of this application. It should be noted that a person of ordinary skill in the art may make several improvements or modifications to the embodiments of this application without departing from the principle of the embodiments of this application, and the improvements or modifications should fall within the protection scope of the claims of the embodiments of this application.

## Claims

1. A synchronization mechanism, comprising a base, a slider, and a first swing arm and a second swing arm that are located on two sides of the slider, wherein both the first swing arm and the second swing arm are rotatably connected to the base, and the slider is slidably disposed parallel to an axial direction in which the first swing arm and the second swing arm rotate;
a protruding portion is disposed on each of the first swing arm and the second swing arm, an end surface of one of the protruding portion and the slider has a helical surface, and an abutting portion that fits with the corresponding helical surface is disposed on an end surface of the other one of the protruding portion and the slider; and
the synchronization mechanism further comprises an elastic component, the helical surface elastically abuts against the abutting portion under an action of the elastic component, and when the first swing arm and the second swing arm rotate, the helical surface and the abutting portion fit with each other to drive the slider to axially slide, so that the first swing arm and the second swing arm rotate at a same angle relative to the base.

2. The synchronization mechanism according to claim 1, wherein both the first swing arm and the second swing arm are of a split-type structure, the first swing arm and the second swing arm each comprise a first swing sub-arm and a second swing sub-arm that are capable of synchronously rotating, the first swing sub-arm and the second swing sub-arm are capable of axially moving relative to each other, and at least one of the first swing sub-arm and the second swing sub-arm has the protruding portion.

3. The synchronization mechanism according to claim 2, wherein a protruding portion A is disposed on the first swing sub-arm, a protruding portion B is disposed on the second swing sub-arm, an abutting portion is disposed on each of corresponding end surfaces of the protruding portion A and the protruding portion B, the slider is located between a protruding portion A and a protruding portion B on a same side, and under the action of the elastic component, two axially arranged end surfaces of the slider respectively elastically abut against the protruding portion A and the protruding portion B on the same side.

4. The synchronization mechanism according to claim 3, further comprising a first rotating shaft and a second rotating shaft that are mounted on the base, wherein the first rotating shaft and the second rotating shaft are disposed in parallel, the first swing arm rotates around the first rotating shaft, the second swing arm rotates around the second rotating shaft, and the slider slides along the first rotating shaft and the second rotating shaft.

5. The synchronization mechanism according to claim 4, wherein the protruding portion A and the protruding portion B are provided with coaxial via holes for a rotating shaft on a corresponding side to pass through.

6. The synchronization mechanism according to claim 5, wherein a first sleeve is disposed on each of the two sides of the slider, the first sleeves on the two sides are respectively slidably sleeved on the first rotating shaft and the second rotating shaft, two end surfaces of each of the first sleeves have helical surfaces, and the helical surfaces respectively fit with the abutting portions of the protruding portion A and the protruding portion B.

7. The synchronization mechanism according to claim 5 or 6, wherein a recess is disposed on one of non-hinged ends of the first swing sub-arm and the second swing sub-arm, a protrusion inserted into the recess is disposed on the other one of the non-hinged ends, and the protrusion fits with the recess to implement synchronous rotation between the first swing sub-arm and the second swing sub-arm.

8. The synchronization mechanism according to claim 5, further comprising a third swing arm and a fourth swing arm, wherein the third swing arm and the fourth swing arm are respectively rotatably connected to two sides of the base, and an elastic component is press-fitted between the third swing arm and the first swing arm and between the fourth swing arm and the second swing arm.

9. The synchronization mechanism according to claim 8, further comprising a damping apparatus, wherein the damping apparatus comprises an elastic damping component that is circumferentially limited by the base and that is capable of axially extending or retracting, the third swing arm and the fourth swing arm each have a first concave-convex surface, the elastic damping component has second concave-convex surfaces that are in a one-to-one correspondence with the first concave-convex surfaces and that elastically abut against the first concave-convex surfaces, and when the third swing arm and the fourth swing arm rotate, the first concave-convex surface rotates relative to the second concave-convex surface to provide damping.

10. The synchronization mechanism according to claim 9, wherein two protruding portions C that are axially spaced apart are disposed on each of the third swing arm and the fourth swing arm, the protruding portion C is provided with a through hole for a rotating shaft on a corresponding side to pass through, and a first concave-convex surface is disposed on each of two opposite surfaces of the two protruding portions C.

11. The synchronization mechanism according to claim 10, wherein the elastic damping component comprises a first bracket, a second bracket, and a first elastic member, a second sleeve exists on each of two sides of each of the first bracket and the second bracket, the two second sleeves are respectively sleeved on the first rotating shaft and the second rotating shaft, the first elastic member is press-fitted between the first bracket and the second bracket, and a second concave-convex surface is disposed on an end portion that is of each of the second sleeves and that is away from the first elastic member.

12. The synchronization mechanism according to any one of claims 8 to 11, wherein the elastic component comprises a first elastic component and a second elastic component, the first elastic component is located on an outer side of a rotating shaft of the first swing arm, two ends of the first elastic component are supported on non-hinged ends of the first swing arm and the third swing arm, the second elastic component is located on an outer side of a rotating shaft of the second swing arm, and two ends of the second elastic component are supported on non-hinged ends of the second swing arm and the fourth swing arm.

13. The synchronization mechanism according to claim 12, wherein coaxial first holes are disposed on the third swing arm and non-hinged ends of a first swing sub-arm and a second swing sub-arm on a same side as the third swing arm, a first shaft body is disposed inside the first hole, the first elastic component is sleeved on the first shaft body, coaxial second holes are disposed on the fourth swing arm and non-hinged ends of a first swing sub-arm and a second swing sub-arm on a same side as the fourth swing arm, a second shaft body is disposed inside the second hole, and the second elastic component is sleeved on the second shaft body.

14. The synchronization mechanism according to claim 8, wherein the elastic component comprises two first elastic members, the two first elastic members are respectively sleeved on the first rotating shaft and the second rotating shaft, the first elastic member is circumferentially limited by the base, the second elastic member is circumferentially limited by the base, and at least one end portion of each of the first elastic member and the second elastic member is capable of abutting against and fitting with a concave-convex surface of a swing arm on a corresponding side to provide rotation damping.

15. The synchronization mechanism according to claim 14, wherein the elastic component further comprises a bracket, a second sleeve exists on each of two sides of the bracket, the two second sleeves are respectively sleeved on the first rotating shaft and the second rotating shaft, two elastic components abut against swing arms on corresponding sides by using the bracket, and the two second sleeves fit with concave-convex surfaces of swing arms corresponding to the two second sleeves.

16. The synchronization mechanism according to claim 15, wherein the bracket comprises a first bracket and a second bracket that are located at two ends of the elastic component, the first swing arm and the second swing arm respectively elastically abut against concave-convex surfaces of second sleeves on two sides of the first bracket, and the third swing arm and the fourth swing arm respectively elastically abut against concave-convex surfaces of second sleeves on two sides of the second bracket.

17. The synchronization mechanism according to claim 11 or 16, wherein the elastic component further comprises a second elastic member, the second elastic member is located between the two first elastic members, and a support for mounting the second elastic member is further disposed on each of opposite side surfaces of the first bracket and the second bracket.

18. The synchronization mechanism according to any one of claims 1 to 6, 8 to 11, and 14 to 16, further comprising a shaft body that runs through non-hinged ends of swing arms on a same side of the base, wherein driven by the shaft body, the swing arms on the same side of the base synchronously rotate.

19. The synchronization mechanism according to any one of claims 1 to 6, 8 to 11, and 14 to 16, wherein a guide rail is disposed on one of two opposite surfaces of the base and the slider, a recess that is axially in sliding fit with the guide rail is disposed on the other one of the two opposite surfaces, and the guide rail and the recess axially extend.

20. A rotating shaft mechanism, comprising a pedestal and the synchronization mechanism according to any one of claims 1 to 19, wherein the base is connected to the pedestal fixedly or in a limiting manner.

21. An electronic device, comprising a flexible screen and the rotating shaft mechanism according to claim 20.
